Europäisches Patentamt

European Patent Office

Office européen des brevets

(11) Veröffentlichungsnummer: **0 234 368**
**A1**

(12) **EUROPÄISCHE PATENTANMELDUNG**

(21) Anmeldenummer: 87101662.2

(22) Anmeldetag: 06.02.87

(51) Int. Cl.⁴: **H01L 25/14**

(30) Priorität: 19.02.86 DE 3605337

(43) Veröffentlichungstag der Anmeldung:
02.09.87 Patentblatt 87/36

(84) Benannte Vertragsstaaten:
DE FR GB SE

(71) Anmelder: **Siemens Aktiengesellschaft Berlin
und München**
**Wittelsbacherplatz 2**
**D-8000 München 2(DE)**

(72) Erfinder: **Jahn, Herbert**
**Odenwaldallee 17**
**D-8520 Erlangen(DE)**
Erfinder: **Waedt, Günter**
**Poststrasse 13c**
**D-8550 Forchheim(DE)**

(54) **Turmaufbau für Hochspannungsanlagen.**

(57) Die Erfindung bezieht sich auf einen Turmaufbau
für Hochspannungsanlagen, bestehend aus mehreren Etagen (2 -12), die mittels Isolatoren miteinander
verbunden sind, wobei jede Etage (2 -12) Tragschienen (16) aus elektrisch isolierendem Material
und topfförmige Knotenelemente (24) aufweist. Erfindungsgemäß umspannen die Tragschienen (16) und
metallische Querschienen (26) mittels der Knotenelemente (24) eine viereckige Fläche, wobei in dieser
umspannten Fläche ein Traggerippe (32) aus isolierenden Quer-und Längsträger (34 und 36) angeordnet ist, und daß als topfförmiges Knotenelement -
(24) ein zylindrischer Tragkörper (42) mit einem
axial angeordneten, zylindrischen Kern (44) vorgesehen ist, wobei die Mantelfläche (46) des Knotenelementes (24) mit zwei zueinander rechtwinklig und zu
den Stirnseiten (48) des Tragkörpers (42) rechtwinklig angeordneten Befestigungszapfen (38) versehen
ist. Somit erhält man einen Turmaufbau für Hochspannungsanlagen, der im Baukastensystem unabhängig von der Übertragungsleistung und/oder der
Anzahl der aktiven Bauelemente (14) aufgebaut werden kann.

FIG 3

## Turmaufbau für Hochspannungsanlagen

Die Erfindung bezieht sich auf einen Turmaufbau für Hochspannungsanlagen bestehend aus mehreren Etagen, die mittels Isolatoren miteinander verbunden sind, wobei jede Etage Tragschienen aus elektrisch isolierendem Material und topfförmige Knotenelemente aufweist.

Aus der DE-PS 23 54 663 ist ein Gerüst, aufgebaut aus gleichartigen, miteinander verschraubten Knoten-und Stützelementen, im Baukastensystem für einen Stromrichter bekannt. Die Thyristoren des Stromrichters sind an den Knotenelementen befestigt, wobei die Knotenelemente zur Stromzuführung zu den Thyristoren dienen. Jede Stütze für jede Etage des Gerüstes weist wenigstens ein Knotenelement auf, das als Topf mit mehreren ebenen Seitenflächen ausgebildet ist. Die Knotenelemente jeder Stütze sind über Stützelemente aus elektrisch isolierendem Material miteinander verschraubt. Somit kann man einen Stromrichter in Baukastensystem für verschiedene Spannungen aus gleichen Einzelteilen aufbauen, wobei wenigstens ein Teil der stromführenden Bauteile in das Baukastensystem integriert ist. Außerdem erhält man eine kompakte raumsparende Anordnung.

Außerdem sind Turmaufbauten für Hochspannungsanlagen bekannt, wobei die aktiven Bauelemente eingeschlossen sind, somit also ein Modul darstellen. Durch die Modulbauweise sind doppelte Luft-und Kriechstrecken einzuhalten, was zu großen Abmessungen und damit zu großem Bauvolumen führt. Ferner sind die einzelnen Etagen alle mit Leitblechen verkleidet. Bei verschiedenen Hochspannungsanlagen bzw. bei verschiedenen Ventilstationen sind deren Turmaufbauten unterschiedlich, da die Türme aus keinen einheitlichen Elementen bestehen. Außerdem ist der Spannungsableiter als selbstständiger Säulenaufbau außerhalb des Ventilturms angeordnet, da im Turm kein Platz vorhanden ist.

Der Erfindung liegt nun die Aufgabe zugrunde, einen Turmaufbau für Hochspannungsanlagen so aufzubauen, daß im Baukastensystem Hochspannungsanlagen unabhängig von der Übertragungsleitung oder der Anzahl der aktiven Bauelemente aufgebaut werden können, wobei eine kompakte, raumsparende Anordnung erreicht werden soll.

Diese Aufgabe wird erfindungsgemäß dadurch gelöst, daß die Tragschienen und metallische Querschienen mittels der Knotenelemente eine viereckige Fläche umspannen, wobei in dieser umspannten Fläche ein Traggerippe aus isolierenden Quer-und Längsträger angeordnet ist, und daß als topfförmiges Knotenelement ein zylindrischer Tragkörper mit einem axial angeordneten, zylindrischen Kern vorgesehen ist, wobei die Mantelfläche des Knotenelements mit zwei zueinander rechtwinklig und zu den Stirnseiten des Tragkörpers rechtwinklig angeordneten Befestigungszapfen versehen ist, und daß der zylindrische Kern an seinen Stirnseiten mit axial angeordneten Gewindezapfen verbunden ist.

Bei dem erfindungsgemäßen Turmaufbau für Hochspannungsanlagen wird ein Gerüst aus gleichartigen, miteinander verschraubten Knotenelementen, Isolatoren, Tragschienen und metallischen Querschienen aufgebaut, wobei jeweils ein Traggerippe in der umspannten Fläche jeder Etage angeordnet wird. Die Knotenelemente jeder Etage sind als Verbindungselemente für die Tragschienen, metallischen Querschienen und die Isolatoren, die die einzelnen übereinander angeordneten Etagen des Turmaufbaus gegeneinander abstützen, ausgelegt. Außerdem bilden sie durch die Anordnung der auf der Mantelfläche angeordneten Befestigungszapfen die äußeren Turmkonturen. Im Zusammenhang mit der zylindrischen Mantelfläche - schirmen die Knotenelemente den Turm elektrisch gegen die Umgebung ab, d.h. die Knotenelemente hemmen Teilentladungen. Somit erhält man einen Turmaufbau für Hochspannungsanlagen, der im Baukastensystem unabhängig von der Übertragungsleistung und/oder der Anzahl der aktiven Bauelemente aufgebaut werden kann. Außerdem benötigt man weder bei der Konstruktion noch bei der Montage ein besonders geschultes Personal.

In einer vorteilhaften Ausführungsform des Turmaufbaus ist der zylindrische Kern mit einem zylindrischen, axial angeordneten Durchbruch versehen, wobei ein Ende des Durchbruchs mit einem Sackloch versehen ist, ist eine Gewindestange mit Hilfe einer Gewindemutter und des Sackloches in dem Durchbruch des Knotenelementes angeordnet und ragen die freien Enden der Gewindestangen als Gewindezapfen aus dem Durchbruch des Knotenelementes heraus.

Bei dieser vorteilhaften Ausführungsform können die Knotenelemente in Serienfertigung, vorzugsweise als Metallstück, preiswert hergestellt werden. Außerdem sind so die Teile des Turmaufbaus, gemäß eines Baukastensystems, in derartiger Weise weiter vereinfacht, so daß nur noch Halbwerkzeuge als Einzelelemente des Baukastensystems verwendet werden, wodurch die Herstellung des Turmaufbaus preiswerter geworden ist.

In einer weiteren vorteilhaften Ausführungsform des Turmaufbaus sind als Isolatoren Freiluftisolatoren mit einer glasfaserverstärkten Kunststoffseele vorgesehen und die Enden der Freiluftisolatoren sind jeweils mit einem Sackloch mit Innengewinde versehen. Bei dieser Ausführungsform sind Freiluftisolatoren vorgesehen, weil sie eine ausgeprägte Rippenform haben, die bei direktem Spritzwasserkontakt die Benetzung unterbricht und dadurch kein Überschlag erfolgt. Durch die glasfaserverstärkte Kunststoffseele erhält der Turmaufbau eine zusätzliche Stabilität, selbst dann, wenn bei einem Schadensfall, beispielsweise einem Stoß gegen die Stützer, das Gießharz der Freiluftisolatoren bricht.

In einer weiteren vorteilhaften Ausführungsform des Turmaufbaus dienen die metallischen Querschienen und die Knotenelemente zur Stromführung. Somit sind gesonderte Bauteile für die Stromzuführung zu den aktiven Bauelementen praktisch nicht mehr vorhanden. Außerdem erhält man bei jedem metallischen offenen Aufbau jede Etage ein günstiges Potentialverhältnis, das sehr einfach abgesteuert werden kann.

In einer weiteren Ausführungsform des Turmaufbaus ist in jeder Etage des Turmaufbaus ein Übespannungsableiter angeordnet, dessen Enden jeweils mit einem Traggerippe verbunden ist.

Durch diese Integration des Überspannungsableiters in dem Turm verringert man weiter das Volumen des Turmaufbaus. Außerdem können so fertige und vorgeprüfte einheiten zur Turmmontage verwendet werden, so daß die Vielzahl der zu montierenden Teile minimiert werden.

In einer besonders vorteilhaften Ausführungsform des Turmaufbaus sind jeweils zwei gegenüberliegende Seiten jeder Etage zusätzlich mit einem mittleren Knotenelement versehen, das jeweils zwischen den Knotenelementen der gegenüberliegenden Seiten angeordnet ist, und dieses mittlere Knotenelement ist mit zwei Befestigungszapfen für die isolierenden Tragschienen und zwei Befestigungszapfen für die metallischen Querschienen versehen.

Durch dieses zusätzliche Knotenelement werden die Stromschienen mittig an die Etagenmitte angebunden, so daß die Spannungsabstände am Anfang und am Ende jeder Etage halbiert werden. Dadurch wird erreicht, daß mehrere Turmaufbauten auf kleinen Raum nebeneinander aufgestellt werden können. Somit erhält man ein minimales Volumen für eine mehrventilige Hochspannungsanlage, d.h. mehrere nebeneinander angeordnete Ventiltürme.

Zur weiteren Erläuterung der Erfindung wird auf die Zeichnung Bezug genommen, in der ein Ausführungsbeispiel des Turmaufbaus für Hochspannungsanlagen nach der Erfindung schematisch veranschaulicht ist.

FIG 1 zeigt einen Turmaufbau gemäß der Erfindung mit jeweils einem zusätzlichen mittig angeordneten Knotenelement, in

FIG 2 ist ein Schnitt längs der Linie II-II der FIG 1 dargestellt und die

FIG 3 veranschaulicht ein Knotenelement des erfindungsgemäßen Turmaufbaus.

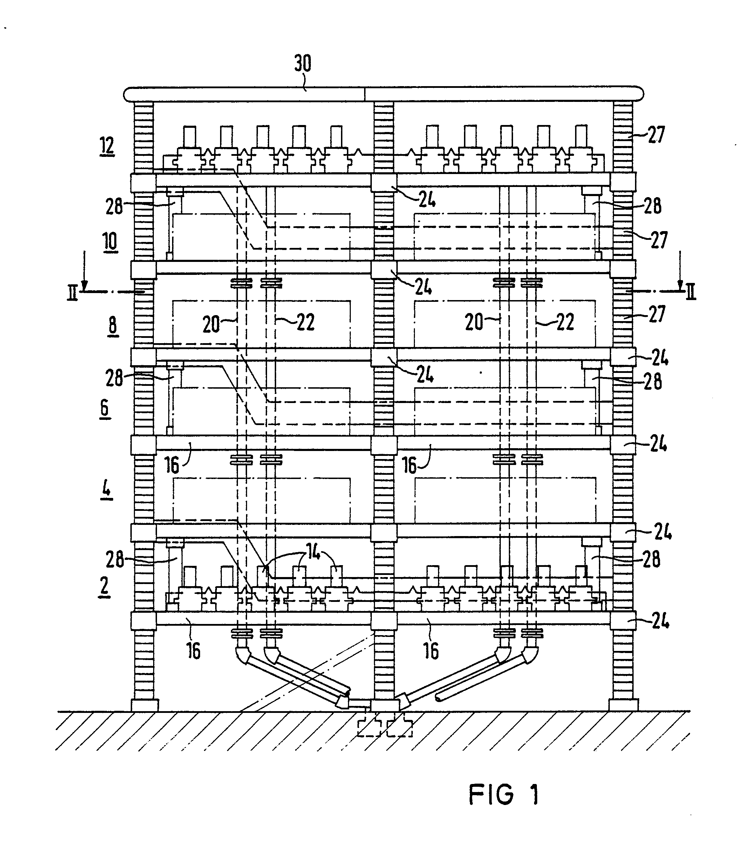

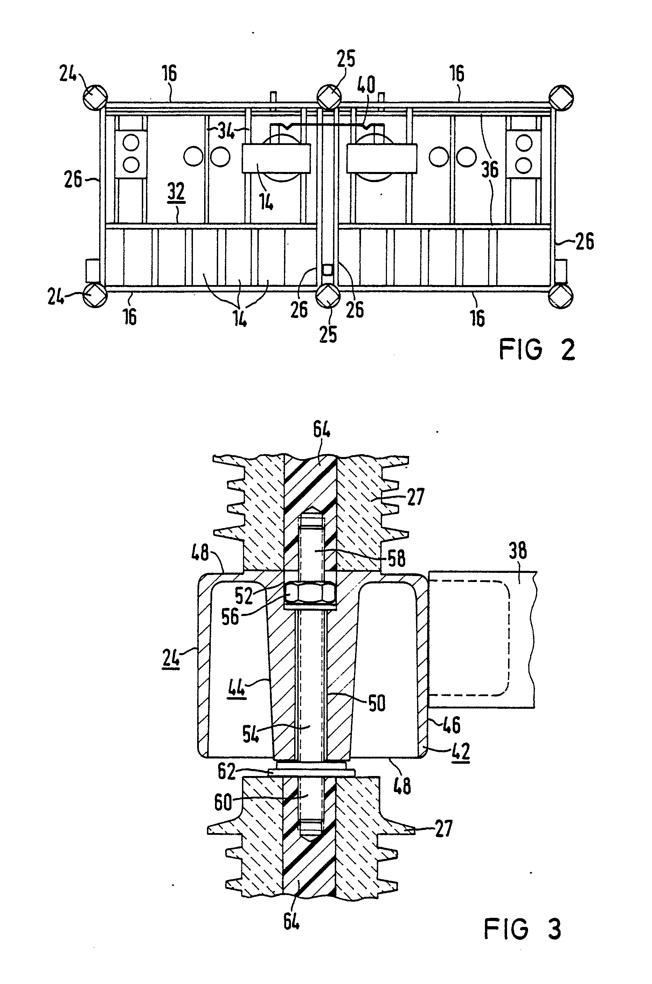

In der Darstellung gemäß FIG 1 ist ein Turmaufbau für eine Hochspannungsanlage, beispielsweise ein Doppelventilturm einer Hochspannungsgleichstromübertragungsanlage HGÜ-Anlage, dargestellt. In Stapelbauweise sind in sechs Etagen 2, 4, 6, 8, 10 und 12 nebeneinander angeordnete, aktive Bauelemente 14, beispielsweise steuerbare Stromrichterventile, auf Tragschienen 16 und Längsträger 18 angeordnet. Als steuerbare Stromrichterventile können flüssigkeitsgekühlte Thyristoren verwendet werden. Aus einer gemeinsamen Kühlflüssigkeitszuleitung 20 wird jede Etage 2, 4, 6, 8, 10 und 12 des Turmaufbaus mit Kühlflüssigkeit versorgt. Über eine gemeinsame Kühlflüssigkeitsableitung 22 fließt das Kühlmittel wieder von den Thyristoren ab. Jede Etage 2, 4, 6, 8, 10 und 12 enthält mehrere Knotenelemente 24, mehrere Tragschienen 16 und mehrere metallische Querschienen 26, wie näher aus der FIG 2 zu erkennen ist. Die Etage 2, 4, 6, 8, 10 und 12 sind über Freiluftisolatoren 27, die jeweils mit den Knotenelementen 24 verbunden sind, miteinander verbunden. Außerdem ist in mehreren Etagen 2, 6 und 8 jeweils ein Überspannungsableiter 28 im Turmaufbau integriert. Diese Verteilung der Überspannungsanleiter 28 im Turmaufbau ist von der zu realisierenden elektrischen Ausrüstung des Turms abhängig. Außerdem sind die Enden des Überspannungsableiters 28 jeweils mit aus dem Turm herausführenden Ableithörner versehen. Im Fehlerfall des Überspannungsableiters 28 kann ein vorhandener Lichtbogen über die Ableithörner und mit Hilfe der Stromkräfte, die durch die entgegengesetzte Stromschienenführung wirken, aus dem Ventilbereich gedrückt werden, wodurch Folgeschäden vermieden werden. Die oberste Etage 12 ist mit einem Ventildach 30 abgedeckt, das ebenfalls über Freiluftisolatoren 27 mit den Knotenelementen 24 dieser Etage 12 verbunden ist. Durch diese Ausführung erhält man eine Turmkonstruktion, die aus mehreren Einzelteilen eines Baukastensystems aufgebaut ist. Dabei besteht die Möglichkeit, den Turm unabhängig von der Übertragungsleistung oder der Anzahl der aktiven Bauelemente 14 zu erweitern. Da die aktiven Bauelemente 14 einzeln in die Etagen untergebracht werden, kann gemäß der Überspannungsfestigkeit das Bauvolumen des Turms verkleinert werden. Auch die Einbeziehung des Überspannungsableiters 28 in den Turm verringert das Bauvolumen der Turmkonstruktion eines Ventilturms einer HGÜ-Anlage. Durch die standardisierten Einzelteile des Turms, die miteinander verschraubt werden können, benötigt man kein besonders geschultes Personal. Außerdem ist der Turmaufbau für alle Anwendungen in der Hochspannungstechnik zu verwenden. Somit erhält man ein Baukastensystem, das einen einfachen Aufbau von Turmaufbauten von Hochspannungsanlagen gewährleistet.

Die FIG 2 zeigt einen Schnitt längs der Linie II-II der FIG 1. Dieser Schnitt verdeutlicht den Aufbau der Etagen 2, 4, 6, 8, 10 und 12 des Turmaufbaus für Hochspannungsanlagen. Jede Etage 2, 4, 6, 8, 10 und 12 des Turmaufbaus enthält mindestens zwei Tragschienen 16 aus isolierendem Material und zwei metallische Querschienen 26, die mittels der Knotenelemente 24 eine viereckige Fläche umspannen. In dieser umspannten Fläche ist ein Traggerippe 32 angeordnet. Das Traggerippe 32 besteht aus Quer- und Längsträger 34 und 36 aus isolierendem Material, die miteinander und mit den Tragschienen 16 und den metallischen Querschienen 26 verbunden sind. Die aktiven Bauelemente 14, beispielsweise Thyristoren, werden von einer Tragschiene 16 und einem Längsträger 36 getragen, wobei das aktive Bauelement 14 beispielsweise die Ventildrossel, von zwei Querträger 34 getragen wird. Außerdem sind jeweils zwei gegenüberliegende Seiten jeder Etage 2, 4, 6, 8, 10 und 12 zusätzlich mit einem mittleren Knotenelement 25 versehen, das jeweils zwischen den Knotenelementen 24 der gegenüberliegenden Seiten angeordnet ist. Dieses mittlere Knotenelement 25 ist mit zwei Befestigungszapfen 38 für die isolierenden Tragschienen 16 und zwei Befestigungszapfen 38 für die metallischen Querschienen 26 versehen. Die Gestaltung der Befestigungszapfen 38 kann man der FIG 3 entnehmen. Als isolierende Quer- und Längsträger 34 und 36 des Traggerippes 32 können Flachprofilschienen oder quaderförmige Hohlträger vorgesehen sein. Die metallischen Querschienen 26 können aus einem Strangpreßprofil hergestellt sein. Außerdem dienen die metallischen Querschienen 26 und die Knotenelemente 24 und 25 zur Stromführung. Dabei ist gemäß der FIG 2 die Mittenanbindung mittels einer Stromschiene 40 an der Etagenmitte zu bevorzugen. Dadurch wird erreicht, daß die Spannungsabstände am Anfang und am Ende der Etagen halbiert sind, wodurch eine sehr günstige Potentialteilung entsteht, die sehr einfach abgesteuert werden kann. Durch diese Gestaltung jeder Etage 2, 4, 6, 8, 10 und 12 erhält man eine stabile und einfach zusammensetzbare Konstruktion. Durch den identischen Aufbau der Etagen 2, 4, 6, 8, 10 und 12 kann man mit entsprechender Anzahl von Etagen einen Turm für Hochspannungsanlagen ohne weiteren Konstruktion-und Entwicklungsaufwand erstellen.

In FIG 3 ist ein Schnitt längs eines topfförmigen Knotenelementes 24 veranschaulicht. Als topfförmiges Knotenelement 24 ist ein zylindrischer Tragkörper 42 mit einem axial angeordneten, zylindrischen Kern 44 vorgesehen. Die Mantelfläche 46 des Knotenelementes 24 ist mit zwei zueinander rechtwinklig und zu den Stirnseiten 48 des Tragkörpers 42 rechtwinklig angeordneten Befestigungszapfen 38 versehen. Der zylindrische Kern 44 des Tragkörpers 42 ist mit einem zylindrisch, axial angeordneten Durchbruch 50 versehen. Dieser Durchbruch 50 ist an einem Ende mit einem Sackloch 52 versehen. Durch den Durchbruch 50 ist eine Gewindestange 54 geführt, die mit Hilfe des Sackloches 52 und einer Gewindemutter 56 derartig gelagert ist, daß die freien Enden der Gewindestange 54 als Gewindezapfen 58 und 60 aus dem Tragkörper 52 herausragen. Auf diesen Gewindezapfen 58 und 60 ist jeweils ein Freiluftisolator 27 geschraubt. Dabei sind zwischen dem zylindrischen Kern 44 und dem einen Freiluftisolator 27 noch Distanzscheiben 62 angeordnet. Außerdem können auch noch Ausgleichslager eingesetzt werden. Die Distanzscheiben 62 dienen beim Aufbau zur Turmnivelierung, wobei die Ausgleichslager dazu dienen beim Verschrauben die Querkräfte zu vermeiden. Die Freiluftisolatoren 27 haben eine ausgeprägte Rippenform, so daß bei direktem Spritzwasserkontakt die Benetzung unterbrochen wird. Dadurch wird ein Überschlag vermieden. Außerdem sind die Freiluftisolatoren 27 mit einer glasfaserverstärkten Kunststoffseele 64 versehen. Damit die Freiluftisolatoren 27 auf die Gewindezapfen 58 und 60 geschraubt werden können, sind die Freiluftisolatoren 27 jeweils an ihren Endbereichen mit einem Sackloch mit Innengewinde versehen. Dieses Sackloch ist in der glasfaserverstärkten Kunststoffseele 64 angeordnet. Somit verläuft der Kraftfluß geradlinig und mittig durch die Freiluftisolatoren 27 und die Knotenelemente 24 und damit durch den gesamten Ventilturm. Durch die glasfaserverstärkte Kunststoffseele 64 erhält der Ventilturm eine zusätzliche Stabilität. Bei einem Schadensfall, beispielsweise einem Stoß gegen die Freiluftisolatoren 27, sorgt die glasfaserverstärkte Kunststoffseele 64 bei Bruch des Gießharzes für genügend Stabilität, so daß der Ventilturm nicht einstürzen kann. Durch die Gestaltung dieser Knotenelemente 24 sind die Einzelteile des Turmaufbaus gemäß eines Baukastensystems, auf einfache Halbwerkzeuge als Einzelelemente vereinfacht. Dadurch ist die Herstellung der Einzelelemente einfach und der Zusammenbau zu einem Turm kostengünstig.

**Ansprüche**

1. Turmaufbau für Hochspannungsanlagen bestehend aus mehreren Etagen (2 -12), die mittels Isolatoren miteinander verbunden sind, wobei jede Etage (2 -12) Tragschienen (16) aus elektrisch isolierendem Material und topfförmige Knotenelemente (24) aufweist, **dadurch gekennzeichnet,** daß die Tragschienen (16) und metallische Querschienen (26) mittels der Knotenelemente (24) eine viereckige Fläche umspannen, wobei in dieser umspannten Fläche ein Traggerippe (32) aus isolierenden Quer-und Längsträger (34 und 36) angeordnet ist, und daß als topfförmiges Knotenelement - (24) ein zylindrischer Tragkörper (42) mit einem axial angeordneten, zylindrischen Kern (44) vorgesehen ist, wobei die Mantelfläche (46) des Knotenelementes (24) mit zwei zueinander rechtwinklig und zu den Stirnseiten (48) des Tragkörpers (42) rechtwinklig angeordneten Befestigungszapfen - (38) versehen ist, und daß der zylindrische Kern - (44) an seinen Stirnseiten (48) mit axial angeordneten Gewindezapfen (58, 60) verbunden ist.

2. Turmaufbau nach Anspruch 1, **dadurch gekennzeichnet,** daß der zylindrische Kern (44) mit einem zylindrisch, axial angeordneten Durchbruch - (50) versehen ist, wobei ein Ende des Durchbruchs (50) mit einem Sackloch (52) versehen ist, daß eine Gewindestange (54) mit Hilfe einer Gewindemutter (56) und des Sackloches (52) in dem Durchbruch - (50) des Knotenelementes (24) angeordnet ist, und daß die freien Enden der Gewindestange (54) als Gewindezapfen (58, 60) aus dem Durchbruch (50) des Knotenelementes (24) herausragen.

3. Turmaufbau nach Anspruch 1, **dadurch gekennzeichnet,** daß als Isolatoren Freiluftisolatoren (27) mit einer glasfaserverstärkten Kunststoffseele - (64) vorgesehen sind, und daß die Enden der Freiluftisolatoren (27) jeweils mit einem Sackloch mit Inenngewinde versehen sind.

4. Turmaufbau nach Anspruch 1, **dadurch gekennzeichnet,** daß die metallischen Querschienen (26) und die Knotenelemente (24) zur Stromführung dienen.

5. Turmaufbau nach Anspruch 1, **dadurch gekennzeichnet,** daß in jeder Etage (2 -12) des Turmaufbaus ein Überspannunsableiter (28) angeordnet ist, dessen Enden jeweils mit einem Traggerippe (32) verbunden ist.

6. Turmaufbau nach Anspruch 5, **dadurch gekennzeichnet** , daß die Enden des Überspannungsableiters (28) jeweils mit aus dem Turm herausführende Ableithörner versehen sind.

7. Turmaufbau nach einem der Ansprüche 1 bis 6, **dadurch gekennzeichnet,** daß aktive Bauelemente (14) einzeln auf dem Traggerippe (32) angeordnet sind.

8. Turmaufbau nach Anspruch 1 bis 7, **dadurch gekennzeichnet,** daß jeweils zwei gegenüberliegende Seiten jeder Etage (2 -12) zusätzlich mit einem mittleren Knotenelement (25) versehen sind, das jeweils zwischen den Knotenelementen (24) der gegenüberliegenden Seiten angeordnet ist, und daß dieses mittlere Knotenelement (25) mit zwei Befestigungszapfen (38) für die isolierenden Tragschienen (16) und zwei Befestigungszapfen (38) für die metallischen Querschienen (26) versehen ist.

FIG 1

FIG 2

FIG 3

Europäisches
Patentamt

**EUROPÄISCHER RECHERCHENBERICHT**

Nummer der Anmeldung

EP 87 10 1662

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | FR-A-2 250 201 (SIEMENS) | | H 01 L 25/14 |
| A | EP-A-0 076 439 (TOSHIBA) | | |
| A | FR-A-2 170 237 (LICENTIA) | | |
| A | DE-B-1 273 074 (SIEMENS) | | |

RECHERCHIERTE
SACHGEBIETE (Int. Cl.4)

H 01 L

Der vorliegende Recherchenbericht wurde für alle Patentansprüche erstellt.

| Recherchenort | Abschlußdatum der Recherche | Prüfer |
|---|---|---|
| DEN HAAG | 18-05-1987 | DE RAEVE R.A.L. |